Europäisches Patentamt

European Patent Office

Office européen des brevets

(11) Publication number: **0 615 203 A1**

## EUROPEAN PATENT APPLICATION

(21) Application number: **94103786.3**

(22) Date of filing: **11.03.94**

(51) Int. Cl.5: **G06F 15/60**

(30) Priority: **11.03.93 JP 51031/93**

(43) Date of publication of application:
**14.09.94 Bulletin 94/37**

(84) Designated Contracting States:
**DE FR GB**

(71) Applicant: **KABUSHIKI KAISHA TOSHIBA**
**72, Horikawa-cho**
**Saiwai-ku**
**Kawasaki-shi Kanagawa-ken 210 (JP)**
Applicant: **TOSHIBA AVE CO., LTD**
**3-9, Shinbashi 3-chome**

**Minato-ku Tokyo (JP)**

(72) Inventor: **Shinbara, Seitaro**
**1-17-11-406, Namiki,**
**Kanazawa-ku**
**Yokohama-shi, Kanagawa-ken (JP)**

(74) Representative: **Lehn, Werner, Dipl.-Ing. et al**
**Hoffmann, Eitle & Partner,**
**Patentanwälte,**
**Arabellastrasse 4**
**D-81925 München (DE)**

(54) **Method and apparatus for fitting circuit parameter.**

(57) On the basis of the fact that the number of physical /geometrical parameters is smaller than that of the device parameters of an equivalent circuit model, the device parameters of the equivalent circuit are optimized on the basis of the device parameters obtained by converting the physical /geometrical parameters. When the obtained device parameters are not converged, the physical/geometrical parameters are updated so as to be converged to a convergent point quickly.

F I G. 2

EP 0 615 203 A1

## BACKGROUND OF THE INVENTION

### Field of the Invention

The present invention relates to a method and apparatus for fitting circuit parameters of an equivalent circuit model, and more specifically a method and apparatus for optimizing circuit parameters of an equivalent circuit model of a device under design in order to analyze the device operation.

### Description of the Prior Art

In the simulation for analyzing the operation of a transistor circuit, it has been a general method in which a simulated circuit is designed using equivalent circuit models of elements (e.g., BJT (bipolar junction transistors), FETs, etc.) which constitute a circuit to be simulated, and then the operation of the simulation circuit is examined. In this simulation, parameter fitting is required to adjust and optimize the characteristics of the simulation circuit elements so as to be equivalent to those of the actual circuit elements.

As the conventional parameter fitting method, there has been so far adopted such a cut-and-try method in which calculation formulae are solved; an actual integrated circuit is manufactured; and the actual operation of the manufactured; the manufactured circuit is tested; these procedures are repeated. However, this method is extremely difficult when the circuit scale is as large as an LSI circuit. In addition, in the conventional method, it has been actually impossible to simulate operation of the LSI circuit with the use of a computer.

To overcome this method, a method of operating a simulation circuit on a computer has been developed. In this case, the typical equivalent circuit model now being used is Gummel-Poon model. This Gummel-Poon model is an equivalent circuit model composed of BJTs, and includes 44 device parameters representative of various devices (e.g., resistances, capacitances, etc.) for constituting the equivalent circuit.

This method of fitting circuit parameters is usually executed by software referred to as an optimizer. In the execution of the circuit parameter fitting by the optimizer, the $V_{CE}$ - $I_c$ characteristic, for instance of the simulation circuit is measured actually; the measured characteristic values are compared with the characteristic value calculated on the basis of the set device parameters; the set device parameters are adjusted in such a way that the deviation value between two characteristic values can be reduced; and the above-mentioned processing is repeated until each of the deviation values of the various characteristics determined on the basis of the various parameters can be converged within an allowable value, respectively. The development of above-mentioned optimizer has so far allowed various circuits to be analyzed accurately, and therefore contributed to the current progress of the LSI circuits.

In the conventional circuit parameter fitting method, however, since a great number of device parameters are included in the equivalent circuit model, there exists a problem in which a long time is required to analyze the circuit. The reason is as follows: since the optimizer basically adopts the least square method, the calculation speed to obtain characteristic deviation value between the actual value and the calculated value slows down with increasing number of parameters, and then the time required for the convergence of the calculation in the above-mentioned processing increases drastically.

In addition, in the circuit parameter fitting, without being limited to only the above-mentioned $V_{CE}$ - $I_C$ characteristic, various other characteristics must be analyzed; i.e. all the characteristics to be analyzed must be optimized; and the deviation values must be converged to obtain the final target values of the device parameters. When the fitting process is executed always under consideration of all the characteristics, however, there exists a problem in that the convergence cannot be obtained ever after a long time. In this case, in general, at the stage where a certain characteristic is converged to some extent, the analyzing process is switched to another characteristic analysis. In practice, however, since the parameters are not independent from each other but have a mutual relationship with respect to each other, when second characteristic is processed for circuit parameter fitting on the basis of a convergent value of the first characteristic, the obtained convergent value largely deviates from the actual value, or a lot of stable convergent values are eventually obtained, with the result that there exists a problem in that a set of convergent points suitable for all the characteristics cannot be obtained.

## SUMMARY OF THE INVENTION

Accordingly, it is the primary object of the present invention to provide circuit parameter fitting method, by which it is possible to obtain secure convergent points, reduce the processing time required for the characteristic convergence, and decrease the convergent points.

Further, the secondary object of the present invention is to provide the circuit parameter fitting apparatus, by which it is possible to obtain secure convergent points, reduce the processing time required for the characteristic processing, and decrease the convergent points.

According to the primary invention, there is provided a method of fitting circuit parameters, comprising the steps of:

a first step of setting initial values related to physical/geometrical parameters of a device;

a second step of converting the set physical/geometrical parameters into device parameters of a previously selected equivalent circuit model of the device, respectively;

a third step of calculating a characteristic on the basis of the equivalent circuit model, respectively;

a fourth step of comparing the calculated characteristic value with an actual characteristic value, to obtain a difference between the two for each characteristic;

a fifth step of, when the obtained difference is larger than an allowable range, updating the physical/geometrical parameters so as to reduce the difference, and repeating the second to fourth steps; and

a sixth step of, when the obtained difference is smaller than the allowable range, outputting the device parameters, respectively as convergent values.

According to the secondary invention, there is also provided an apparatus for fitting circuit parameters, comprising:

initial value setting means for setting initial values related to physical/geometrical parameters of a device;

converting means responsive to said initial value setting means, for converting the set physical/geometrical parameters into device parameters of a previously selected equivalent circuit model of the device, respectively;

characteristics calculating means for calculating characteristics on the basis of the equivalent circuit model, respectively;

comparing means for comparing the calculated characteristic value with an actual characteristic value, to obtain a difference between the two for each characteristic;

updating means for updating the physical/geometrical parameters so as to reduce the obtained difference, when the obtained difference is out of a predetermined allowable range; and

optimum value determining means for deciding the device parameters as the optimum values, when the obtained difference is within the predetermined allowable range.

In these inventions, since physical/geometrical parameters are updated on the basis of the result of comparison characteristics calculated using device parameters which are converted from physical/geometrical parameters (whose number is smaller than that of the device parameters) with characteristics of an actual device, it is possible to reduce the analysis time required for the processing by that extent and further to suppress the dispersion of the convergent points.

BRIEF DESCRIPTION OF THE DRAWINGS

In the attached drawings:

Fig. 1 is a block diagram showing a circuit parameter fitting apparatus related to the present invention;

Fig. 2 is a flowchart showing an embodiment of the circuit parameter fitting algorithm according to the present invention;

Fig. 3 is a circuit diagram showing a Gummel-Poon model, as an example of an equivalent circuit whose parameters are to be fitted;

Fig. 4 is a graphical representation showing the $V_{be}$ -$I_B$, $I_C$ characteristics, as examples of the characteristics to be analyzed by the parameter fitting method in the Gummel-Poon model; and

Fig. 5 is a graphical representation showing the $I_C$ -$\beta$ characteristic of the same Gummel-Poon model.

DETAILED DESCRIPTION OF THE PREFERRED EMBODIMENTS

The features of the present invention are first described.

As already explained, the Gummel-Poon model is known as an equivalent circuit model of BJTs (bipolar Junction transistors). Further, in this case, the Gummel-Poon model includes 44 device parameters. Here, it is known that these 44 device parameters can be replaced with 15 physical/geometrical parameters (referred to as P/G parameters simply, hereinafter) by the document: Mark Rencher, "Analog Statistical Simulation for Bipolar Integrated Circuit", Analog Integrated and Signal Processing 1, pp 157 to 164 (1991), for instance.

The device parameters represent the resistances, capacitances, etc. of the equivalent circuit model, and the P/G parameters represent the physical and geometrical parameters of the BJTs, FETs, etc. In the case of the BJTs, for instance, the P/G parameters correspond to the impurity concentrations, areas, depths, etc. of a substrate and of base, emitter and collector regions.

Since the P/G parameters are closely relevant to the actual elements, when the device parameters are obtained on the basis of these P/G parameters, it is possible to reduce the device parameters to be actually adjusted.

The embodiment of the present invention will be described hereinbelow with reference to the attached drawings.

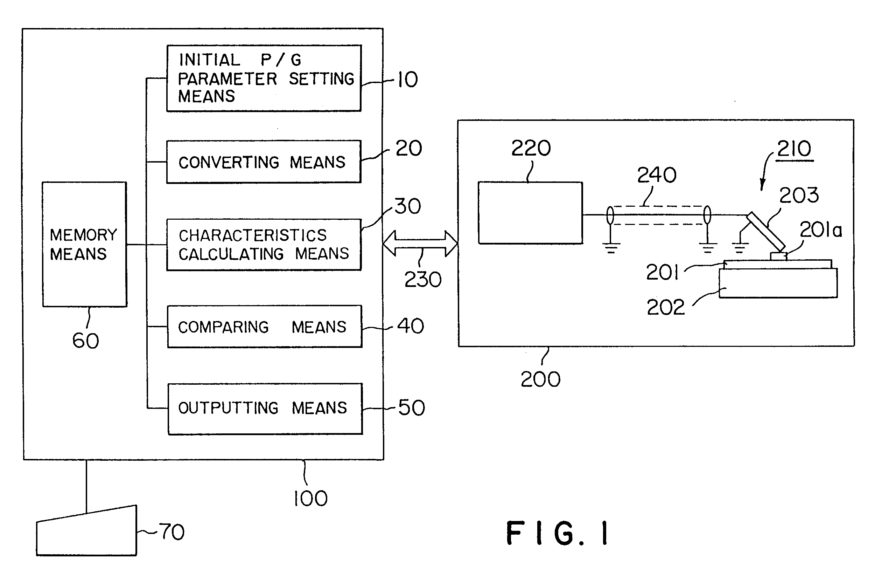

Fig. 1 is a block diagram showing an apparatus for optimizing the circuit parameters according to the present invention.

The apparatus shown in Fig. 1 is composed of a control equipment 100 such as an engineering work station (EWS) or a computer and measurement data generating means 200 for obtaining actual measurement values of a device.

The control system 100 includes P/G parameter initial value setting means 10 for setting initial values of the P/G parameters; converting means 20 for converting the P/G parameters into device parameters of the Gummel-Poon model, respectively; characteristic calculating means 30 for calculating the characteristics of the Gummel-Poon model; comparing means 40 for comparing the characteristic value calculated by the characteristic calculating means with the measured data obtained by the measurement data generating means to check whether the comparison result lies within a predetermined allowable range, for each characteristics; output means 50 for outputting device parameters when the comparison results reach the allowable range, respectively; and storing means 60 for storing input data and various data to be calculated. Further, the control system 100 is provided with input means 70 such as a keyboard for entering data.

The measurement data generating means 200 is composed of a high frequency prober 210 and a measurement instrument 220. The high frequency prober 210 includes a support base 202 for supporting a wafer 201 in which an integrated circuit has been formed, and a probing head 203 brought into contact with a predetermined position, e.g., pads on the wafer 201 to supply voltage or current thereto and to receive the measurement data therefrom. The probing head 203 is composed of two fine (several μm) needle-shaped electrodes arranged in parallel to each other in correspondence to a signal line and a ground line Further, the probing head 203 can be brought into contact with a pad 201a formed on the wafer 201. The characteristic impedance of this probing head 203 is 50 ohms at a tip of the needle. The measurement instrument 220 is connected to the control system 100 via a standard bus (GP-IB standard) 230 for the measurement instruments, and further connected to the high frequency probe 210 via a coaxial cable with a characteristic impedance of 50 ohms.

In operation, the measurement instrument 220 supplies voltage and current for measurement to the high frequency probe 210 on the basis of command values applied by the control system 100, measures the voltage and current obtained by the wafer 201, and transmits the measured data to the control system 100. The transmitted measurement data are compared with the calculated data by the comparing means 40.

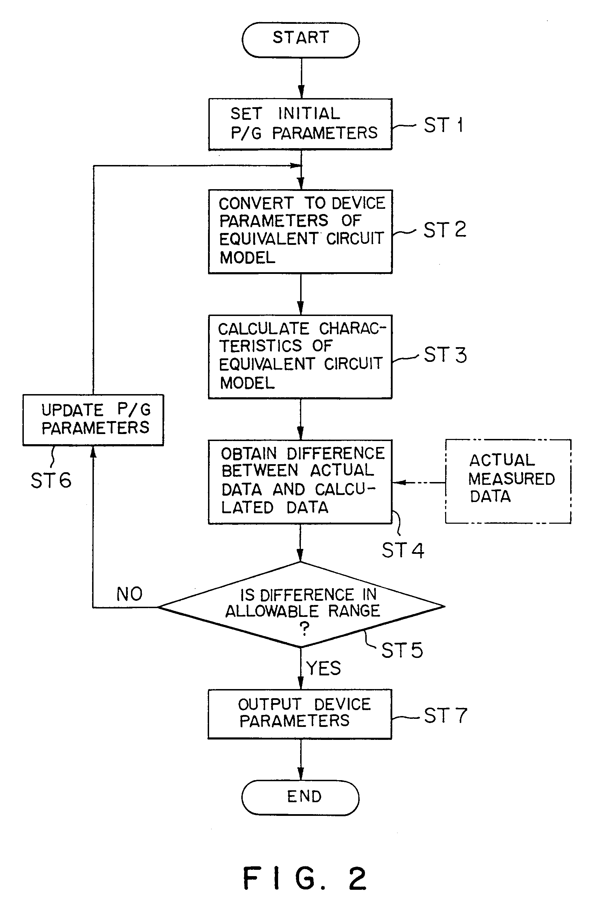

Fig. 2 is a flowchart showing the parameter fitting processing related to the embodiment of the present invention.

In the method of the present invention, in step ST1, the control system 100 (referred to as control, hereinafter) sets the initial data of the physical/geometrical (P/G) parameters representative of the device parameters to be fitted in an equivalent circuit. The number of the P/G parameters to be set initially is 15 parameters, as already explained.

Successively, in step ST2, control converts the P/G parameters set in the step ST1 into 44 device parameters in accordance with predetermined conversion formulae to extract the Gummel-Poon model. The conversion formulae are also known by the afore-mentioned document.

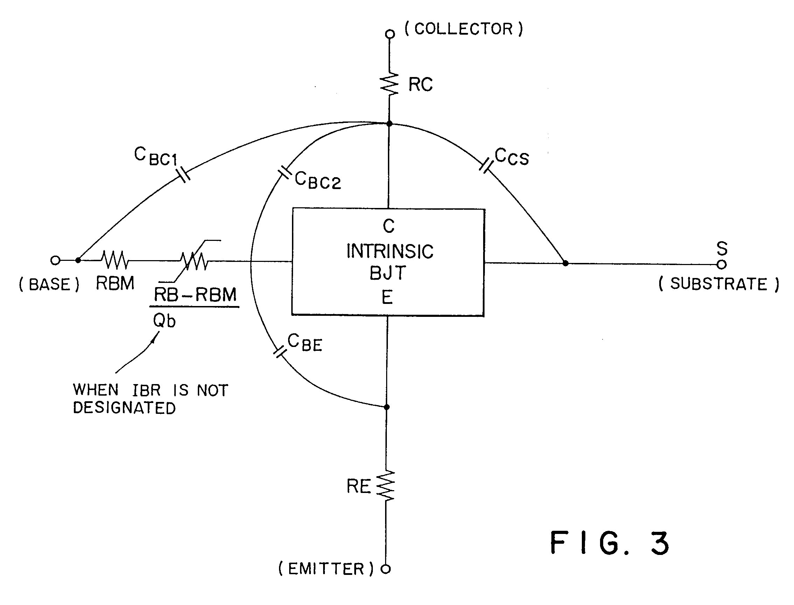

Fig. 3 shows a circuit configuration of the Gummel-Poon model. In the device parameters shown in Fig. 3, RC denotes a collector series resistance; RE denotes an emitter series resistance; RB denotes a zero-bias base resistance; RBM denotes a minimum base resistance; $C_{CS}$ denotes a capacitance between the collector and the substrate; $C_{BE}$ denotes a capacitance between the base and the emitter; $Q_b$ denotes a normalized base charge quantity; $B_{BCI}$ denotes $C_{BC} * (1-XCJC)$; and $B_{BCZ}$ denotes $C_{BC} * XCJC$. These device parameters can be represented by the conversion formulae with the P/G parameters as variables, for instance as follows:

$$RBM = EBS / LE \cdot psbe \cdot SCB$$

where EL denotes the emitter length of the transistor; psbe denotes the sheet resistance of the base under the emitter; SCB denotes the diffusion base resistance change; and EBS denotes the resistance distance between the emitter and the base.

The relationship as described above exists for each of all the 44 device parameters, so that it is possible to represent the 44 device parameters by the 15 P/G parameters. Therefore, in step ST2, 44 device parameters can be obtained in accordance with the relationships as described above to complete the Gummel-Poon model.

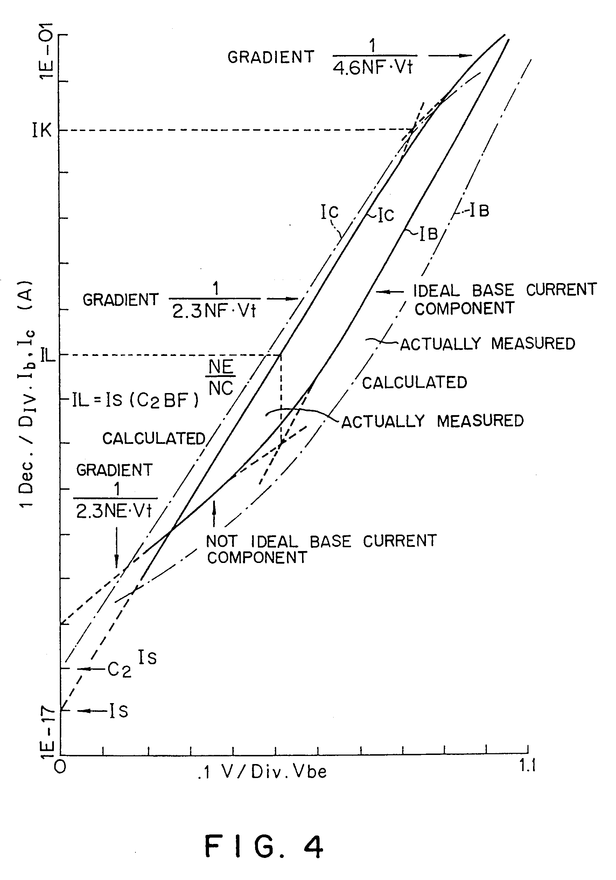

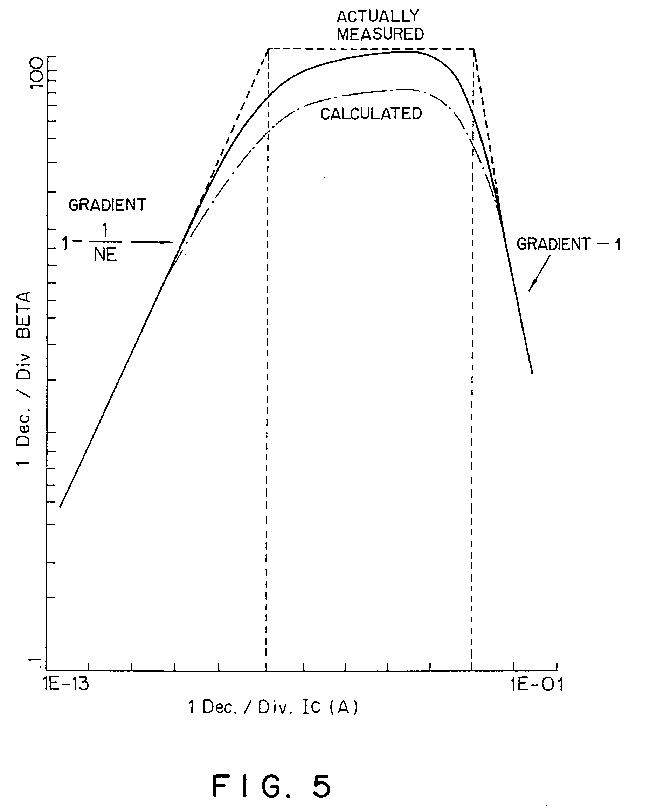

In step ST3, the characteristics of the Gummel-Poon model are obtained by calculation. The characteristics obtained in step ST3 are the $V_{be}$ - $I_b$ characteristic, the $V_{be}$ $I_c$ characteristic, the $I_c$ - $\beta$ characteristic, etc. In this step, the information data enough to describe the respective characteristic curve as shown by a dot-dashed line shown in Figs. 4 and 5 can be obtained for each processing. Fig. 4 shows Gummel plot curves, in which the $V_{be}$ - $I_b$ and $V_{be}$ - $I_c$ characteristics are both shown. In the same way, Fig. 5 shows the $I_c$ - $\beta$ characteristic.

In step ST4, control compares the characteristic obtained in step ST3 with the actually obtained value. In this step ST4, the deviation value between the actually obtained value (shown by a solid line) and the calculated value (shown by a dot-dashed line) is calculated in accordance with the least square method, for each characteristic. The reason why the least square method is adopted is that it is possible to prevent the deviation value between both from being canceled by the positive and negative values. The obtained deviation value between the two is stored in an exclusive work area of the memory 60 of the control system 100 temporarily.

Successively, in step ST5, control discriminates whether the calculated deviation value stored at the work area lies within a predetermined allowable range or not. If the discriminated result indicates that the deviation value is out of the allowable range, in step ST6, control changes the P/G parameter and returns to step ST2. Therefore, Control obtains the device parameters corresponding to the changed P/G parameter again, and discriminates whether the obtained deviation value lies within an allowable range. The above steps ST2 to ST4 are repeated until the discrimination result of YES can be obtained.

When control discriminates that the deviation value between the calculated data and the measured data lies within an allowable range in step ST5, in step ST7 control outputs the discriminated device parameters of the Gummel-Poon model as the data at the convergent point. The above-mentioned processing is repeated until each of the deviation values of the various characteristics obtained on the basis of the converted device parameters can be converged within the respective allowable range.

In the above-mentioned analysis processing in accordance with the algorithm in step ST5, a plurality of the allowable ranges of different values are prepared for the respective characteristic; the one characteristic and one allowable range are paired; and the algorithms are exchanged and executed until the deviation value can be converged in the respective pairs.

As described above, in the method according to the present invention, the P/G parameters are set; the set P/G parameters are converted into the device parameters to obtain an equivalent circuit; and the P/G parameters are adjusted on the basis of the characteristic discrimination results. Therefore, the circuit parameters can be optimized by use of the P/G parameters whose number is smaller than that of the device parameter, so that it is possible to suppress the dispersion at the convergent points and thereby to shorten the analysis time.

## Claims

1. A method of fitting circuit parameters, comprising the steps of:
   a first step of setting initial values related to physical/geometrical parameters of a device;
   a second step of converting the set physical/geometrical parameters into device parameters of a previously selected equivalent circuit model of the device, respectively;
   a third step of calculating a characteristic on the basis of the equivalent circuit model, respectively;
   a fourth step of comparing the calculated characteristic value with an actual characteristic value, to obtain a difference between the two for each characteristic;
   a fifth step of, when the obtained difference is larger than an allowable range, updating the physical/geometrical parameters so as to reduce the difference, and repeating the second to fourth steps; and
   a sixth step of, when the obtained difference is smaller than the allowable range, outputting the device parameters, respectively as convergent values.

2. The method of fitting circuit parameters as set forth in claim 1, wherein the equivalent circuit model of the device is a Gummel-Poon model.

3. The method for fitting circuit parameters as set forth in claim 2, wherein said physical /geometrical parameters include at least impurity concentrations, areas, depths of a substrate, and those in base, emitter and collector regions, and said device parameters include at least a collector series resistance, an emitter series resistance, a zero-bias base resistance, a minimum base resistance, capacitance between the collector and the substrate, a capacitance between the base and the emitter, a normalized base charge quantity.

4. An apparatus for fitting circuit parameters, comprising:
   initial value setting means (10) for setting initial values related to physical/geometrical parameters of a device;
   converting means (20) responsive to said initial value setting means, for converting the set physical/geometrical parameters into device parameters of a previously selected equivalent circuit model of the device, respectively;
   calculating means (30) for calculating characteristics of the equivalent circuit model using converted device parameters;
   comparing means (40) for comparing the calculated characteristic value with an actual characteristic value, to obtain a difference between the two for each characteristic;

updating means (40) for updating the physical/geometrical parameters so as to reduce the obtained difference, when the obtained difference is out of a predetermined allowable range; and

optimum value (50) determining means for deciding the device parameters as the optimum values, when the obtained difference is within the predetermined allowable range.

5. The apparatus of fitting circuit parameters of claim 3, wherein the equivalent circuit model of the device is a Gummel-Poon model.

6. The method for fitting circuit parameters as set forth in claim 3, wherein said physical/geometrical parameters include at least impurity concentrations, areas, depths in the substrate, and in base, emitter and collector regions, and said device parameters include at least a collector series resistance, an emitter series resistance, a zero-bias base resistance, a minimum base resistance, capacitance between the collector and the substrate, a capacitance between the base and the emitter, a normalized base charge quantity.

FIG. 1

START

SET INITIAL
P/G PARAMETERS ── ST 1

CONVERT TO DEVICE
PARAMETERS OF
EQUIVALENT CIRCUIT
MODEL ── ST 2

CALCULATE CHARAC-
TERISTICS OF
EQUIVALENT CIRCUIT
MODEL ── ST 3

UPDATE P/G
PARAMETERS

ST 6

OBTAIN DIFFERENCE
BETWEEN ACTUAL
DATA AND CALCU-
LATED DATA ── ← ── ACTUAL
MEASURED
DATA

ST 4

NO ── IS DIFFERENCE IN
ALLOWABLE RANGE
? ── ST 5

YES

OUTPUT DEVICE
PARAMETERS ── ST 7

END

F I G. 2

FIG. 3

EP 0 615 203 A1

F I G. 4

ACTUALLY
MEASURED

CALCULATED

GRADIENT

$1 - \dfrac{1}{NE} \longrightarrow$

GRADIENT $-$ 1

1 Dec. / Div BETA

100

.1

1E$-$13

1E$-$01

1 Dec. / Div. Ic (A)

# FIG. 5

11

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| D,A | ANALOG INTEGRATED CIRCUITS AND SIGNAL PROCESSING, vol.1, 1991, BOSTON pages 157 - 164 RENCHER 'Analog Statistical Simulation for Bipolar Integrated Circuits' * the whole document * | 1,4 | G06F15/60 |
| A | 1990 IEEE INTERNATIONAL SYMPOSIUM ON CIRCUITS AND SYSTEMS, vol.1, May 1990, NEW ORLEANS, USA pages 85 - 88 NGO ET AL 'A Process and Geometry Driven Device Macro Model for Statistical Simulation of Bipolar IC's' * the whole document * | 1,4 | |

TECHNICAL FIELDS
SEARCHED     (Int.Cl.5)

G06F

The present search report has been drawn up for all claims

| Place of search | Date of completion of the search | Examiner |
|---|---|---|
| BERLIN | 14 June 1994 | Nicholls, J |

EPO FORM 1503 03.82 (P04C01)